# FASCICULE DE BREVET EUROPEEN

(11) **EP 2 345 094 B1**
(45) Date de publication et mention de la délivrance du brevet: **19.09.2012**
(21) Numéro de dépôt: 09752204.9
(22) Date de dépôt: 13.10.2009
(51) Int. Cl.: H01L 37/04, F25B 21/00, F25B 29/00

(54) **GENERATEUR THERMIQUE MAGNETOCALORIQUE**
MAGNETOKALORISCHER THERMISCHER GENERATOR
MAGNETOCALORIC THERMAL GENERATOR

(30) Priorité: 16.10.2008 FR 0805725
(43) Date de publication de la demande: 20.07.2011
(73) Titulaire: Cooltech Applications S.A.S., 67810 Holtzheim (FR)
(72) Inventeur: HEITZLER Jean-Claude, F-68180 Horbourg-Wihr (FR); MULLER Christian, F-67000 Strasbourg (FR)
(74) Mandataire: Nithardt, Roland
(86) Numéro de dépôt international: PCT/FR2009/001200
(87) Numéro de publication internationale: WO 2010/043782

(56) Documents cités:
- WO-A-2007/026062
- WO-A1-2004/059221
- FR-A- 2 904 098
- FR-A- 2 914 051

## Description

### Domaine technique :

La présente invention concerne un générateur thermique comportant des éléments magnétocaloriques disposés en cercle autour d'un axe central, un arrangement magnétique constitué par des zones aimantées et des zones non aimantées alternées, situées à l'intérieur du cercle formé par les éléments magnétocaloriques, ledit arrangement magnétique étant mis en rotation autour dudit axe central et coopérant avec un organe de fermeture de champ agencé pour boucler le flux magnétique généré par lesdites zones aimantées afin de soumettre alternativement lesdits éléments magnétocaloriques à une variation de champ magnétique et créer alternativement dans chaque élément magnétocalorique un cycle d'échauffement et un cycle de refroidissement, de manière synchronisée avec la circulation d'au moins un fluide caloporteur agencé pour traverser lesdits éléments magnétocaloriques au cours des cycles d'échauffement et de refroidissement.

### Technique antérieure:

La technologie du froid magnétique est connue depuis plus d'une vingtaine d'années et on sait les avantages qu'elle apporte en termes d'écologie et de développement durable. On connaît également ses limites quant à sa puissance calorifique utile et à son rendement. Dès lors, les recherches menées dans ce domaine tendent toutes à améliorer les performances d'un tel générateur, en jouant sur les différents paramètres, tels que la puissance d'aimantation, les performances de l'élément magnétocalorique, la surface d'échange entre le fluide caloporteur et les éléments magnétocaloriques, les performances des échangeurs de chaleur, etc.

A cet effet, plusieurs types de générateurs thermiques à éléments magnétocaloriques sont connus, et notamment les générateurs magnétocaloriques comportant une structure circulaire dans laquelle les éléments magnétocaloriques sont disposés en cercle autour d'un axe central et soumis à un champ magnétique variable permettant de créer de manière alternative dans chacun desdits éléments magnétocaloriques un cycle d'échauffement et un cycle de refroidissement. Un tel générateur est décrit dans la demande de brevet français n° 07 / 07612 au nom de la demanderesse. Dans ce générateur, l'énergie thermique générée par des éléments magnétocaloriques est échangée avec un fluide caloporteur mis en déplacement à travers lesdits éléments magnétocaloriques par l'intermédiaire de moyens de circulation. La variation du champ magnétique est réalisée par des zones aimantées et des zones non aimantées alternées tournant autour dudit axe central situées à l'intérieur de l'anneau formé par les éléments magnétocaloriques. Elles sont associées à un dispositif de fermeture de champ réalisé sous la forme d'un anneau et disposé autour des éléments magnétocaloriques pour fermer ou boucler le flux magnétique généré par lesdites zones aimantées à travers lesdits éléments magnétocaloriques.

L'utilisation d'un tel anneau, sensiblement circulaire, est courante dans les générateurs magnétocaloriques connus. Il est en général réalisé à partir d'un matériau ferromagnétique disposé autour des éléments magnétocaloriques, en contact ou à proximité de ces derniers. Ledit anneau est réalisé d'un seul tenant. Un tel anneau présente toutefois un certain nombre d'inconvénients.

Un premier inconvénient concerne la capacité limitée de cet anneau d'assurer le retour du champ magnétique entre deux zones aimantées. En effet, il consiste en une grande masse métallique usinée et peu structurée dans laquelle les fibres cristallines ou métallurgiques sont inexistantes ou orientées de manière aléatoire et ne favorisent pas l'obtention d'une forte induction dans ledit anneau. De plus, la réalisation de cet anneau est onéreuse en termes de pertes de matière.

Le second inconvénient inhérent à l'utilisation d'un tel anneau réside dans le fait que ce dernier est composé d'un matériau thermiquement conducteur , ce qui entraîne un transfert d'énergie thermique entre l'anneau et les éléments magnétocaloriques (pertes thermiques) et réduit donc la capacité thermique du générateur thermique dans lequel il est implanté. En effet, l'énergie thermique produite par les éléments magnétocaloriques est destinée à être échangée avec un fluide caloporteur traversant ces derniers, et non avec l'anneau assurant le retour de champ magnétique.

La demande française FR 2904098 divulgue aussi un générateur selon le préambule de la revendication 1.

### Exposé de invention :

La présente invention vise à pallier ces inconvénients en proposant un générateur thermique comportant des éléments magnétocaloriques et un organe de fermeture de champ de réalisation simple, peu coûteuse et d'efficacité améliorée.

Dans ce but, l'invention concerne un générateur thermique du genre indiqué en préambule, caractérisé en ce que l'organe de fermeture de champ comporte un moyen d'isolation thermique.

De préférence, et selon une première variante de réalisation de l'invention, l'organe de fermeture de champ peut être constitué par au moins une bande de tôle en matériau magnétiquement conducteur, enroulée sur elle-même, disposée autour desdits éléments magnétocaloriques et recouverte, au moins en partie, par une couche de matériau isolant thermiquement formant le moyen d'isolation thermique.

Par bande de tôle, il faut comprendre une bande de matériau réalisée par laminage à chaud ou à froid. Ce procédé permet de créer des lignes de flux magnétiques orientées dans le sens du laminage et permet ainsi d'obtenir, dans l'organe de fermeture de champ, une direction privilégiée du flux magnétique, et donc d'augmenter facilement et de manière efficace le rendement du générateur thermique.

Selon une seconde variante, l'organe de fermeture de champ peut être constitué par au moins une bande de tôle en matériau magnétiquement conducteur, enroulée sur elle-même, disposée autour desdits éléments magnétocaloriques et comprenant, entre ses tours successifs, au moins en partie, une couche de matériau isolant thermiquement formant le moyen d'isolation thermique.

Selon une troisième variante, l'organe de fermeture de champ peut être constitué par au moins une bande de tôle en matériau magnétiquement conducteur, enroulée sur elle-même, disposée autour desdits éléments magnétocaloriques, dont les tours successifs sont espacés les uns des autres et dans lequel le moyen d'isolation thermique est constitué par le volume d'air situé entre lesdits tours successifs.

Dans chacune des variantes précitées, l'organe de fermeture de champ peut être constitué par un assemblage d'au moins deux bandes de tôle disposées côte à côte et de manière espacée les unes des autres.

Pour augmenter l'isolation thermique, l'organe de fermeture de champ peut également comporter un moyen d'isolation thermique formé par un anneau en matière thermiquement isolante et intégré dans l'espace situé entre deux bandes de tôle adjacentes.

Selon l'invention, le moyen d'isolation thermique peut être un vernis en une matière thermiquement isolante recouvrant au moins une face de ladite bande de tôle.

En outre, l'organe de fermeture de champ peut être composé, au moins en partie, de fer ou d'un alliage de fer avec l'un des matériaux choisi dans la liste constituée par le cobalt et le silicium.

Pour augmenter l'efficacité de l'organe de fermeture de champ, ladite bande de tôle enroulée peut comporter au moins une découpe dans laquelle peut être intégré un dispositif de canalisation des lignes de champ magnétique, s'étendant longitudinalement dans ledit organe de fermeture de champ et disposé en regard d'un élément magnétocalorique.

Ledit dispositif de canalisation des lignes de champ magnétique peut être constitué par un assemblage de pièces réalisées en un matériau magnétiquement conducteur, disposées chacune dans un plan radial dudit organe de fermeture de champ, côte à côte et espacées les unes des autres.

En outre, lesdites pièces peuvent être séparées les unes des autres par un matériau thermiquement isolant.

De préférence, ledit dispositif de canalisation des lignes de champ magnétique peut présenter une forme trapézoïdale dont la base située en regard d'un élément magnétocalorique présente sensiblement la même largeur que ce dernier et dont la base opposée présente une largeur inférieure.

En outre, des aimants permanents peuvent former les zones aimantées de l'arrangement magnétique.

### Description sommaire des dessins :

La présente invention et ses avantages apparaîtront mieux dans la description suivante d'un mode de réalisation donné à titre d'exemple non limitatif, en référence aux dessins annexés, dans lesquels:
- la figure 1 est une vue en coupe simplifiée d'un générateur thermique selon l'invention, selon son axe central,
- la figure 2 est une vue du détail B1 de la figure 1,
- la figure 3 est une vue en coupe selon le plan P1 de la figure 1,
- la figure 4 est une vue similaire à celle de la figure 1, d'une variante de réalisation du générateur selon l'invention,
- la figure 5 est une vue du détail B2 de la figure 4, et
- la figure 6 est une vue en coupe selon le plan P2 de la figure 4,
- la figure 7 est une vue similaire à celle de la figure 3, d'une autre variante de réalisation du générateur selon l'invention,
- la figure 8 est une vue en coupe selon le plan B de la figure 7, et
- les figures 9 et 10 sont des vues des détails C et D de la figure 8.

### Illustrations de l'invention :

Dans les exemples de réalisation illustrés, les pièces ou parties identiques portent les mêmes références numériques.

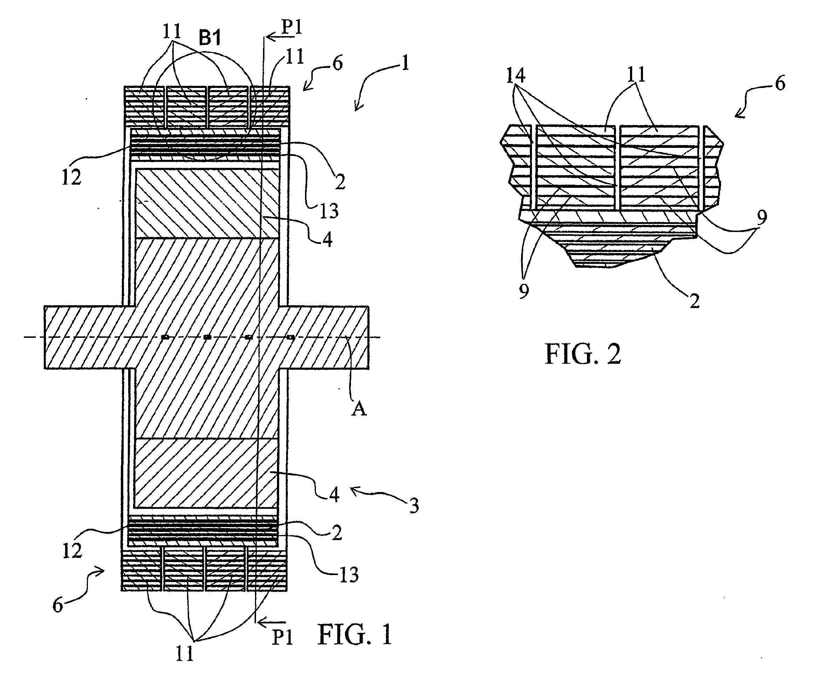

En référence aux figures 1, 2 et 3, le générateur 1 selon l'invention est constitué par un assemblage d'éléments magnétocaloriques 2 disposés en cercle autour d'un axe central A.

Lesdits éléments magnétocaloriques 2 sont soumis à une variation de champ magnétique réalisée par la rotation d'un arrangement magnétique 3 autour dudit axe central A, ledit arrangement magnétique 3 coopérant avec un organe 6 de fermeture de champ agencé pour boucler le flux magnétique généré par l'arrangement magnétique 3. Cette variation de champ magnétique entraîne une alternance de cycles d'échauffement et de refroidissement dans chaque élément magnétocalorique 2.

L'arrangement magnétique 3 comporte des aimants permanents 4 séparés les uns des autres d'un angle de 90° et de polarités opposées créant ainsi des zones aimantées 4 alternées avec des zones non aimantées 5. Une autre configuration adaptée peut évidemment être choisie.

Un fluide caloporteur est mis en circulation à travers lesdits éléments magnétocaloriques 2 de manière synchronisée avec la variation du champ magnétique. Le déplacement de ce fluide caloporteur, en relation avec la variation dudit champ magnétique permet de créer, puis de maintenir, un gradient de température entre les deux extrémités opposées 12 et 13 de chaque élément magnétocalorique 2.

Ces éléments magnétocaloriques 2 sont donc perméables au fluide caloporteur et peuvent être constitués par un ou plusieurs matériaux magnétocaloriques. Ils comportent des passages de fluide débouchants qui peuvent être constitués par les pores d'un matériau poreux, des mini ou micro-canaux usinés dans un bloc plein ou obtenus par un assemblage de plaques rainurées superposées, par exemple.

Les moyens permettant de faire circuler le fluide caloporteur à travers chaque élément magnétocalorique 2 ne sont pas représentés. Ils peuvent être des pistons disposés au niveau d'une ou des deux extrémités de chaque élément magnétocalorique, par exemple, ou tout autre moyen permettant d'imprimer un mouvement de va et vient audit fluide caloporteur.

De même, le générateur thermique selon l'invention est destiné à échanger de l'énergie thermique avec un ou plusieurs circuits extérieurs d'utilisation (chauffage, climatisation, tempérage, etc.) en y étant relié par l'intermédiaire d'un échangeur de chaleur, par exemple, ou tout autre moyen adapté et non représenté.

De manière avantageuse, l'organe 6 de fermeture de champ magnétique est réalisé à partir de quatre bandes de tôle 11, chacune étant enroulée sur elle-même et comportant une couche de vernis 9 en un matériau thermiquement isolant formant un moyen d'isolation thermique. Ces quatre bandes de tôle 11 sont constituées en un alliage fer-cobalt et sont adjacentes les unes aux autres avec un espace libre entre elles. Elles sont disposées autour des éléments magnétocaloriques 2 et assurent la fermeture du champ magnétique généré par les aimants 4 de l'arrangement magnétique 3.

L'utilisation de bandes de tôle 11 pour réaliser l'organe 6 de fermeture de champ permet de réduire les coûts de revient de ce dernier. En effet, le procédé d'usinage de tôles est largement maîtrisé et entraîne moins de pertes de matériau que le procédé de taille. De plus, le roulage desdites bandes de tôle 11 est également facile à mettre en oeuvre et permet une adaptation aisée à tout diamètre de générateur thermique.

Le laminage et l'enroulement desdites bandes de tôle 11 sur elles-mêmes permettent en outre de favoriser, au sein de l'organe 6 de fermeture de champ, une induction maximale, et donc d'augmenter l'intensité du flux magnétique traversant chaque élément magnétocalorique 2 et, de ce fait, d'augmenter l'efficacité et le rendement thermique du générateur thermique 1 selon l'invention.

L'utilisation desdites bandes de tôle 11 permet également d'y intégrer un moyen d'isolation thermique empêchant un échange thermique entre l'organe 6 de fermeture de champ et les éléments magnétocaloriques 2 adjacents à ce dernier ce, sur la longueur des éléments magnétocaloriques et à leurs extrémités 12 et 13 au niveau desquelles la différence de température est maximale.

Ainsi, grâce à ce vernis 9, l'organe 6 de fermeture de champ assure sa fonction de bouclage du flux magnétique (la fermeture des lignes de champ magnétique) entre deux aimants permanents 4 en rotation, sans dissiper l'énergie thermique produite par les éléments magnétocaloriques 2.

En outre, les espaces libres 14 entre les bandes de tôle 11 adjacentes améliorent encore l'isolation thermique entre l'organe 6 de fermeture de champ et les éléments magnétocaloriques 2, augmentant encore le rendement thermique du générateur thermique 1 selon l'invention.

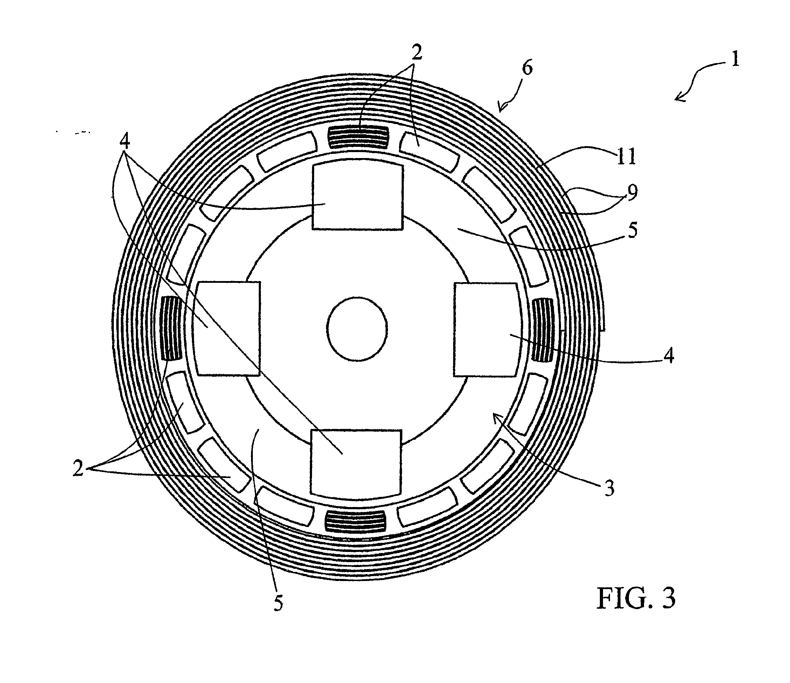

Pour des raisons de simplification, seuls les éléments magnétocaloriques 2 en regard des aimants permanents 4 ont été représentés sur la figure 3.

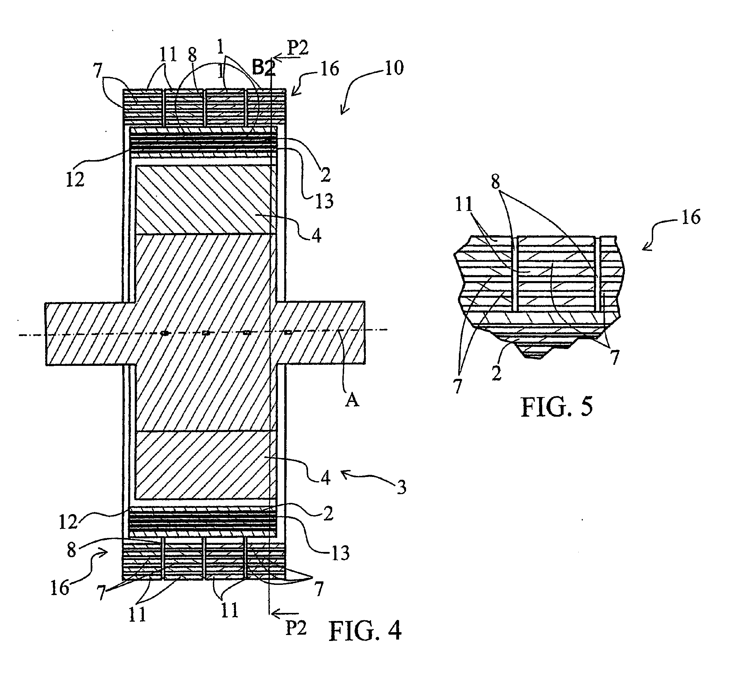

Le générateur thermique 10 représenté sur les figures 4 à 6 se distingue du générateur thermique 1 des figures précédentes par le fait que l'organe 16 de fermeture de champ est constitué par des bandes de tôle 11 entre lesquelles est intercalée une couche 7 plus épaisse réalisée en un matériau thermiquement isolant et que l'espace situé entre deux bandes de tôle 11 adjacentes est rempli par un anneau 8 également réalisé en un matériau thermiquement isolant.

Cette couche 7 de matériau isolant thermiquement forme le moyen d'isolation thermique et est disposée entre les différents tours des bandes de tôle 11, et n'est donc pas appliquée sur une face de ces dernières, comme cela est le cas dans le générateur thermique 1 décrit précédemment.

Il peut, en outre, également être prévu qu'aucune couche de matériau ne soit disposée entre lesdits tours, et que le volume d'air situé entre lesdits tours successifs forme le moyen d'isolation thermique. A cet effet, des moyens d'espacement tels que des entretoises, par exemple, de préférence réalisées en un matériau thermiquement isolant, peuvent être disposées entre les tours successifs.

Ce générateur thermique 10 présente les mêmes avantages que celui décrit plus haut en relation avec les figures 1 à 3.

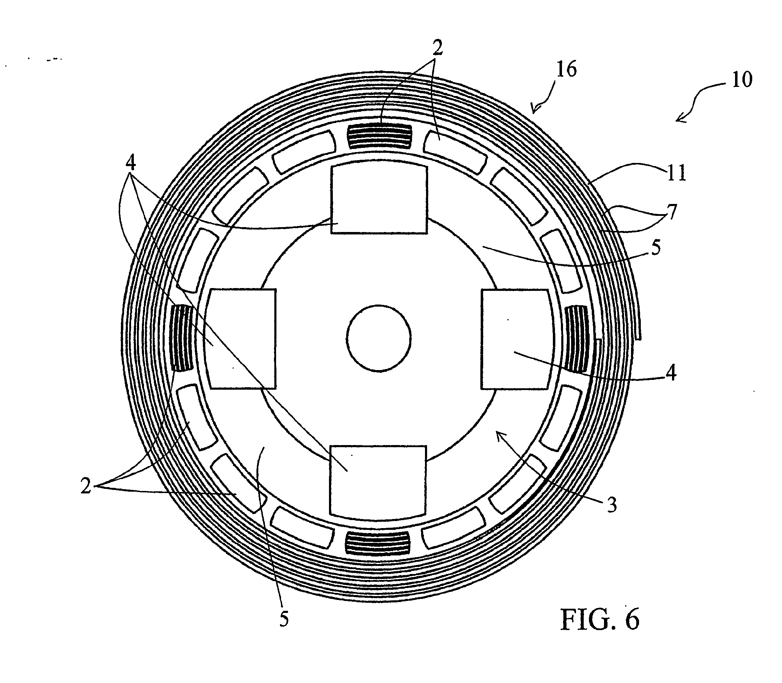

Dans cet exemple de réalisation également, et pour des raisons de simplification de la figure 6, seuls les éléments magnétocaloriques 2 en regard des aimants permanents 4 ont été représentés.

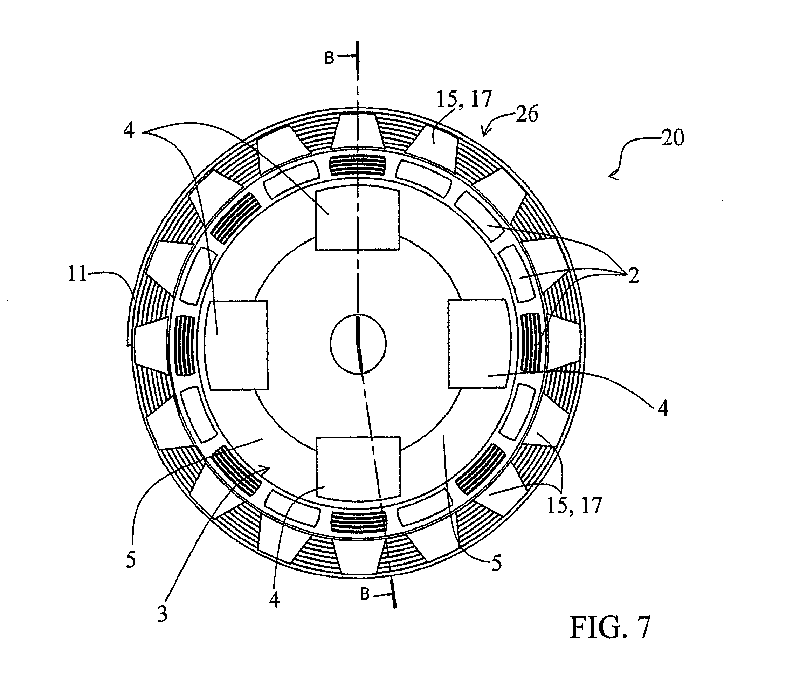

Le générateur thermique 20 représenté sur les figures 7 à 10 se distingue du générateur thermique 1 des figures 1 à 3 par le fait que l'organe 26 de fermeture de champ est constitué par des bandes de tôle 11 qui sont découpées et intègrent un dispositif 15 de canalisation des lignes de champ magnétique au niveau des matériaux magnétocaloriques 2. Un tel dispositif 15 est de préférence, et comme cela ressort de la figure 7, disposé au niveau de chaque élément magnétocalorique 2 et consiste en un dispositif conducteur de lignes magnétiques.

Ce dispositif 15 de canalisation peut être réalisé à partir de pièces 17, telles que par exemple des plaques de tôle découpées, assemblées les unes aux autres selon une ligne longitudinale du générateur thermique 20, en étant espacées. Elles peuvent être réalisées à partir des mêmes bandes de tôle 11 que celles utilisées pour la réalisation de l'organe 26 de fermeture de champ. La position de ces pièces 17 au droit des éléments magnétocaloriques 2 permet d'y canaliser le flux magnétique, ce dernier étant guidé ou bouclé entre deux dispositifs 15 de canalisation successifs par l'intermédiaire des arcs de cercle formés par les bandes de tôle 11 enroulées. L'efficacité du générateur thermique 20 est donc augmentée.

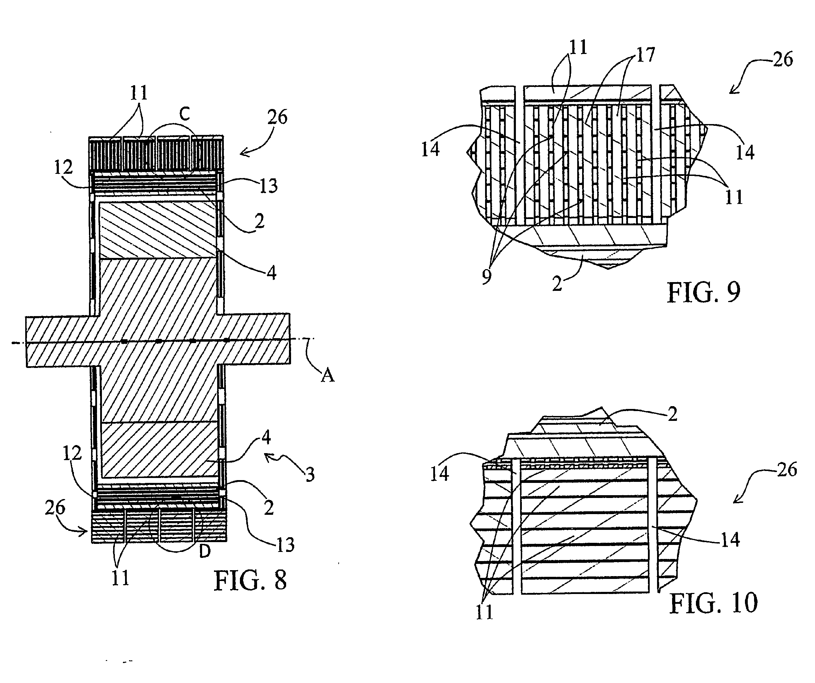

Comme cela ressort plus particulièrement de la figure 9, les pièces 17 constituant ledit dispositif 15 de canalisation sont disposées de manière parallèle les unes aux autres, chacune étant située dans un plan radial autour de l'axe central A. Elles se présentent sous la forme de trapèzes dont la base située en regard d'un élément magnétocalorique 2 présente sensiblement la même largeur que ce dernier et dont la base opposée est plus courte. Une telle configuration permet d'optimiser l'efficacité dudit dispositif 15 de canalisation.

En outre, l'espace entre deux pièces 17 consécutives est de l'air, qui sert également d'isolant thermique et favorise ainsi la réduction des pertes thermiques au niveau du générateur.

Dans cet exemple de réalisation également, et pour des raisons de simplification de la figure 7, tous les éléments magnétocaloriques 2 n'ont pas été représentés.

Dans une variante non représentée, un matériau thermiquement isolant peut être disposé entre lesdites pièces 17 ou appliqué, en partie ou non, sur au moins une face desdites pièces 17. Dans ce dernier cas, ledit matériau isolant peut être sous forme d'un vernis, d'un revêtement ou d'un traitement spécifique, par exemple ou toute autre forme appropriée.

Dans une autre variante non représentée, le dispositif 15 de canalisation peut être sous la forme d'un élément plein ou massif réalisé en un matériau magnétiquement conducteur.

De préférence, et comme cela ressort des figures annexées, l'arrangement magnétique 3 et l'organe de fermeture de champ 6 présentent la même longueur qui correspond également à celle des éléments magnétocaloriques 2. Une configuration différente peut toutefois être envisagée, sans que cela ne sorte du champ de protection de la présente invention. Il en est de même pour ce qui concerne le nombre de bandes de tôle 11 utilisées.

En outre, bien que l'ensemble des dessins annexés illustrent un générateur thermique 1, 10, 20 comportant un seul ensemble circulaire constitué par des éléments magnétocaloriques 2, l'invention prévoit également la réalisation d'un générateur thermique présentant une structure étagée avec plusieurs ensembles. Une telle configuration permet d'augmenter encore le rendement du générateur thermique selon l'invention.

### Possibilités d'application industrielle :

Il ressort clairement de cette description que l'invention permet d'atteindre les buts fixés, à savoir proposer un générateur thermique 1, 10, 20 de construction simple et présentant un coût de revient limité, dans lequel l'organe 6 de fermeture de champ assure sa fonction de bouclage du champ magnétique sans perturber le fonctionnement du générateur thermique 1, 10, 20 ni le rendement thermique de ce dernier.

Un tel générateur thermique 1, 10, 20 peut trouver une application aussi bien industrielle que domestique dans le domaine du chauffage, de la climatisation, du tempérage, refroidissement ou autres, ce, à des coûts compétitifs et dans un faible encombrement.

En outre, toutes les pièces composant ce générateur thermique 1, 10, 20 peuvent être réalisées selon des processus industriels reproductibles.

La présente invention n'est pas limitée aux exemples de réalisation décrits mais s'étend à toute modification et variante évidentes pour un homme du métier tout en restant dans l'étendue de la protection définie dans les revendications annexées.

## Revendications

1. Générateur thermique (1, 10, 20) comportant des éléments magnétocaloriques (2) disposés en cercle autour d'un axe central (A), un arrangement magnétique (3) constitué par des zones aimantées (4) et des zones non aimantées (5) alternées, situées à l'intérieur du cercle formé par les éléments magnétocaloriques (2), ledit arrangement magnétique (3) étant mis en rotation autour dudit axe central (A) et coopérant avec un organe (6) de fermeture de champ agencé pour boucler le flux magnétique généré par lesdites zone aimantées (4) afin de soumettre alternativement lesdits éléments magnétocaloriques (2) à une variation de champ magnétique et créer alternativement dans chaque élément magnétocalorique (2) un cycle d'échauffement et un cycle de refroidissement, de manière synchronisée avec la circulation d'au moins un fluide caloporteur agencé pour traverser lesdits éléments magnétocaloriques (2) au cours des cycles d'échauffement et de refroidissement, générateur thermique (1, 10) **caractérisé en ce que** l'organe (6, 16, 26) de fermeture de champ comporte un moyen (7, 8, 9) d'isolation thermique.

2. Générateur thermique, selon la revendication 1, **caractérisé en ce que** l'organe (6, 26) de fermeture de champ est constitué par au moins une bande de tôle (11) en matériau magnétiquement conducteur, enroulée sur elle-même, disposée autour desdits éléments magnétocaloriques (2) et recouverte, au moins en partie, par une couche (9) de matériau isolant thermiquement formant le moyen d'isolation thermique.

3. Générateur thermique, selon la revendication 1, **caractérisé en ce que** l'organe (16) de fermeture de champ est constitué par au moins une bande de tôle (11) en matériau magnétiquement conducteur, enroulée sur elle-même, disposée autour desdits éléments magnétocaloriques (2) et comprenant, entre ses tours successifs, au moins en partie, une couche (7) de matériau isolant thermiquement formant le moyen d'isolation thermique.

4. Générateur thermique, selon la revendication 1, **caractérisé en ce que** l'organe de fermeture de champ est constitué par au moins une bande de tôle (11) en matériau magnétiquement conducteur, enroulée sur elle-même, disposée autour desdits éléments magnétocaloriques (2), dont les tours successifs sont espacés les uns des autres et dans lequel le moyen d'isolation thermique est constitué par le volume d'air situé entre lesdits tours successifs.

5. Générateur thermique, selon l'une quelconque des revendications 2 à 4, **caractérisé en ce que** l'organe (6, 16, 26) de fermeture de champ est constitué par un assemblage d'au moins deux bandes de tôle (11) disposées côte-à-côte et de manière espacée les unes des autres.

6. Générateur thermique, selon la revendication 5, **caractérisé en ce que** l'organe (16) de fermeture de champ comporte également un moyen d'isolation thermique formé par un anneau (8) en matière thermiquement isolante et intégré dans l'espace situé entre deux bandes de tôle (11) adjacentes.

7. Générateur thermique, selon la revendication 2, **caractérisé en ce que** le moyen d'isolation thermique est un vernis (9) en une matière thermiquement isolante recouvrant au moins une face de ladite bande de tôle (11).

8. Générateur thermique, selon l'une quelconque des revendications précédentes, **caractérisé en ce que** l'organe (6, 16, 26) de fermeture de champ magnétique est composé, au moins en partie, de fer ou d'un alliage de fer avec l'un des matériaux choisi dans la liste constituée par le cobalt et le silicium.

9. Générateur thermique, selon l'une quelconque des revendications 2 à 8, **caractérisé en ce que** ladite bande de tôle (11) enroulée comporte au moins une découpe dans laquelle est intégré un dispositif (15) de canalisation des lignes de champ magnétique, s'étendant longitudinalement dans ledit organe (26) de fermeture de champ et disposé en regard d'un élément magnétocalorique (2).

10. Générateur thermique, selon la revendication 9, **caractérisé en ce que** ledit dispositif (15) de canalisation des lignes de champ magnétique est constitué par un assemblage de pièces (17) réalisées en un matériau magnétiquement conducteur, disposées chacune dans un plan radial dudit organe (26) de fermeture de champ, côte à côte et espacées les unes des autres.

11. Générateur thermique, selon la revendication 10, **caractérisé en ce que** lesdites pièces (17) sont espacées les unes des autres par un matériau thermiquement isolant.

12. Générateur thermique, selon l'une quelconque des revendications 9 à 11, **caractérisé en ce que** ledit dispositif (15) de canalisation des lignes de champ magnétique présente une forme trapézoïdale dont la base située en regard d'un élément magnétocalorique (2) présente sensiblement la même largeur que ce dernier et dont la base opposée présente une largeur inférieure.

13. Générateur thermique, selon l'une quelconque des revendications précédentes, **caractérisé en ce que** des aimants permanents forment les zones aimantées (4) de l'arrangement magnétique (3).

## Claims

1. Heat generator (1, 10, 20) comprising magnetocaloric elements (2) arranged on a circle around a central axis (A), a magnetic arrangement (3) made of alternating magnetized zones (4) and non magnetized zones (5), located inside of the circle formed by the magnetocaloric elements (2), said magnetic arrangement (3) being rotated around said central axis (A) and co-operating with a field closing device (6) arranged to loop the magnetic flux generated by said magnetized zones (4) so as to subject alternately said magnetocaloric elements (2) to a magnetic field variation and create alternately in each magnetocaloric element (2) a heating cycle and a cooling cycle, in synchronisation with the circulation of at least one heat transfer fluid arranged to pass through said magnetocaloric elements (2) during the heating and cooling cycles, heat generator (1, 10) **characterized in that** the field closing device (6, 16, 26) comprises a heat insulation means (7, 8, 9).

2. Heat generator according to claim 1, **characterized in that** the field closing device (6, 26) is made of at least one magnetically conductive sheet metal strip (11), coiled on itself, arranged around said magnetocaloric elements (2) and covered, at least partly, with a layer (9) of heat insulating material that forms the heat insulation means.

3. Heat generator according to claim 1, **characterized in that** the field closing device (16) is made of at least one magnetically conductive sheet metal strip (11), coiled on itself, arranged around said magnetocaloric elements (2) and comprising, between its successive turns, at least partly, a layer (7) of heat insulating material that forms the heat insulation means.

4. Heat generator according to claim 1, **characterized in that** the field closing device is made of at least one magnetically conductive sheet metal strip (11), coiled on itself, arranged around said magnetocaloric elements (2), whose successive turns are spaced out from each other and in which the heat insulation means is made of the air volume located between said successive turns.

5. Heat generator according to any of claims 2 to 4, **characterized in that** the field closing device (6, 16, 26) is made of an assembly of at least two sheet metal strips (11) arranged side by side and spaced out from each other.

6. Heat generator according to claim 5, **characterized in that** the field closing device (16) also comprises a heat insulation means formed by a ring (8) out of a heat insulating material integrated in the space located between two adjacent sheet metal strips (11).

7. Heat generator according to claim 2, **characterized in that** the heat insulation means is a varnish (9) out of a heat insulating material that covers at least one side of said sheet metal strip (11).

8. Heat generator according to any of the previous claims, **characterized in that** the magnetic field closing device (6, 16, 26) is made at least partly of iron or of an iron alloy with one of the materials chosen in the list including cobalt and silicon.

9. Heat generator according to any of claims 2 to 8, **characterized in that** said coiled sheet metal stripe (11) comprises at least one cut-out, in which a canalizing device (15) for the magnetic field lines is integrated, which extends longitudinally in said field closing device (26) and is arranged opposite to a magnetocaloric element (2).

10. Heat generator according to claim 9, **characterized in that** said canalizing device (15) for the magnetic field lines is made of an assembly of parts (17) made out of a magnetically conductive material, arranged each in a radial plane of said field closing device (26), side by side and spaced out from each other.

11. Heat generator according to claim 10, **characterized in that** said parts (17) are spaced out from each other by a heat insulating material.

12. Heat generator according to any of claims 9 to 11, **characterized in that** said canalizing device (15) for the magnetic field lines has a trapezoidal shape, whose base located opposite to a magnetocaloric element (2) has approximately the same width than the latter and whose opposite base has a smaller width.

13. Heat generator according to any of the previous claims, **characterized in that** permanent magnets form the magnetized zones (4) of the magnetic arrangement (3).

## Patentansprüche

1. Thermischer Generator (1, 10, 20) bestehend aus auf einem Kreis um eine Mittelachse (A) angeordneten magnetokalorischen Elementen (2), einer magnetischen Anordnung (3) aus innerhalb des von den magnetokalorischen Elementen (2) gebildeten Kreises angeordneten abwechselnd magnetisierten Bereichen (4) und nicht magnetisierten Bereichen (5), wobei die besagte magnetische Anordnung (3) um die besagte Mittelachse (A) in Drehung versetzt wird und mit einem Element (6) zum Schließen des Magnetfelds zusammenarbeitet, um den von den besagten magnetisierten Bereichen (4) erzeugten Magnetfluss zu schließen, um die besagten magnetokalorischen Elemente (2) abwechselnd einer Magnetfeld-Variation auszusetzen und abwechselnd in jedem magnetokalorischen Element (2) einen Heiz-Zyklus und einen Kühl-Zyklus zu erzeugen, synchronisiert mit der Zirkulation von mindestens einem Wärmeübertragungsfluid das ausgelegt ist, um während der Heiz- und Kühl-Zyklen durch die besagten magnetokalorischen Elemente (2) zu fließen, **dadurch gekennzeichnete**r thermischer Generator (1, 10), dass das Element (6, 16, 26) zum Schließen des Magnetfelds ein Wännedämmmittel (7, 8, 9) beträgt.

2. Thermischer Generator nach Anspruch 1, **dadurch gekennzeichnet, dass** das Element (6, 26) zum Schließen des Magnetfelds aus mindestens einem auf sich selbst aufgerollten Blechstreifen (11) aus einem magnetisch leitenden Material besteht, der um die besagten magnetokalorischen Elemente (2) angeordnet ist und zumindest zum Teil mit einer Schicht (9) aus wärmedämmendem Material bedeckt ist, die das Wärmedämmmittel bildet.

3. Thermischer Generator nach Anspruch 1, **dadurch gekennzeichnet, dass** das Element (16) zum Schließen des Magnetfelds aus mindestens einem auf sich selbst aufgerollten Blechstreifen (11) aus einem magnetisch leitenden Material besteht, der um die besagten magnetokalorischen Elemente (2) angeordnet ist und zwischen seinen aufeinanderfolgenden Windungen zumindest zum Teil eine Schicht (7) aus wärmedämmendem Material beträgt, die das Wärmedämmmittel bildet.

4. Thermischer Generator nach Anspruch 1, **dadurch gekennzeichnet, dass** das Element zum Schließen des Magnetfelds aus mindestens einem auf sich selbst aufgerollten Blechstreifen (11) aus einem magnetisch leitenden Material besteht, der um die besagten magnetokalorischen Elemente (2) angeordnet ist, und dessen aufeinanderfolgende Windungen zwischen sich einen Freiraum aufweisen, und in dem das Wärmedämmmittel aus dem Luftvolumen zwischen den besagten aufeinanderfolgenden Windungen besteht..

5. Thermischer Generator nach einem beliebigen der Ansprüche 2 bis 4, **dadurch gekennzeichnet, dass** das Element (6, 16, 26) zum Schließen des Magnetfelds aus einer Zusammenfiigung von mindestens zwei nebeneinander und in Abstand zueinander angeordneten Blechstreifen (11) besteht.

6. Thermischer Generator nach Anspruch 5, **dadurch gekennzeichnet, dass** das Element (16) zum Schließen des Magnetfelds ebenfalls ein Wärmedämmmittel aufweist, das aus einem Ring (8) aus einem wärmedämmenden Material besteht, der in dem Freiraum zwischen zwei nebeneinander liegenden Blechstreifen (11) eingefügt ist.

7. Thermischer Generator nach Anspruch 2, **dadurch gekennzeichnet, dass** das Wärmedämmmittel ein Lack (9) aus einem wärmedämmenden Material ist, der mindestens eine Seite des besagten Blechstreifens (11) bedeckt.

8. Thermischer Generator nach einem beliebigen der vorhergehenden Ansprüche, **dadurch gekennzeichnet, dass** das Element (6, 16, 26) zum Schließen des Magnetfelds mindestens zum Teil aus Eisen oder aus einer Eisen-Legierung mit einem in der Liste bestehend aus Kobalt und Silizium gewählten Material besteht.

9. Thermischer Generator nach einem beliebigen der Ansprüche 2 bis 8, **dadurch gekennzeichnet, dass** der besagte aufgerollte Blechstreifen (11) mindestens einen Ausschnitt aufweist, in dem eine Vorrichtung (15) zur Kanalisierung der Magnetfeldlinien eingefügt ist, die sich in Längsrichtung in dem besagten Element (26) zum Schließen des Magnetfelds erstreckt und gegenüber eines magnetokalorischen Elements (2) angeordnet ist.

10. Thermischer Generator nach Anspruch 9, **dadurch gekennzeichnet, dass** die besagte Vorrichtung (15) zur Kanalisierung der Magnetfeldlinien aus einer Zusammenfügung von Teilen (17) aus einem magnetisch leitenden Material besteht, die jeweils in einer radialen Ebene des besagten Elements (26) zum Schließen des Magnetfelds, nebeneinander und in Abstand zueinander angeordnet sind.

11. Thermischer Generator nach Anspruch 10, **dadurch gekennzeichnet, dass** die besagten Teile (17) durch ein wärmedämmendes Material in Abstand zueinander angeordnet sind.

12. Thermischer Generator nach einem beliebigen der Ansprüche 9 bis 11, **dadurch gekennzeichnet, dass** die besagte Vorrichtung (15) zur Kanalisierung der Magnetfeldlinien die Form eines Trapez hat, dessen gegenüber eines magnetokalorischen Elements (2) befindliche Basis merklich die selbe Breite als letzteres aufweist und dessen entgegen gesetzte Basis eine geringere Breite aufweist .

13. Thermischer Generator nach einem beliebigen der vorhergehenden Ansprüche, **dadurch gekennzeichnet, dass** Permanentmagnete die magnetisierten Bereiche (4) der magnetischen Anordnung (3) bilden.
